# EUROPEAN PATENT APPLICATION

(11) **EP 4 759 626 A1**
(43) Date of publication of application: **17.06.2026**
(21) Application number: 25762301.7
(22) Date of filing: 20.01.2025
(51) Int. Cl.: B60L 58/18, H02J 7/00, G01R 19/165, G01R 19/10, G01R 31/392, H02J 7/04, B60L 50/60, B60L 3/00, H01M 10/44

(54) **BATTERY PACK AND OPERATION METHOD THEREOF**

(30) Priority: 27.02.2024 KR 20240028246
(71) Applicant: LG Energy Solution, Ltd., Seoul 07335 (KR)
(72) Inventor: JEONG, Doo Ho, Daejeon 34122 (KR)
(74) Representative: Plasseraud IP
(86) International application number: PCT/KR2025/001058
(87) International publication number: WO 2025/183367

(57) **Abstract**

A battery pack according to an embodiment of this document may include a conversion unit that converts a total voltage output from a first battery unit and a second battery unit into an intermediate voltage, a switch circuit unit that switches an electrical connection between the conversion unit and the first battery unit and a load, and a controller that controls an operation of the switch circuit unit to charge the first battery unit and supply power to the load using the intermediate voltage.

## Description

### TECHNICAL FIELD

### Cross-reference to Related Applications

This application claims priority from Korean Patent Application No. 10-2024-0028246, filed on February 27, 2024, the disclosures of which are incorporated by reference herein.

### Technical Field

Embodiments disclosed in this document relate to a battery pack and an operating method thereof.

### BACKGROUND ART

Recently, research and development on secondary batteries have been actively conducted. Here, secondary batteries are batteries that can be charged and discharged, and can be interpreted as encompassing both conventional Ni/Cd batteries, Ni/MH batteries, etc. and recent lithium-ion batteries. Recently, the scope of use of the lithium ion batteries has expanded to include a power source for electric vehicles, and the lithium ion batteries are attracting attention as a next-generation energy storage medium.

Electric vehicles receive electricity from the outside to charge battery cells/modules, and then discharge the battery cells/modules to drive the motor and obtain power. During the production and use stages, battery cells/modules undergo internal deformation and transformation through various charging and discharging, and their physicochemical properties change. Due to such deterioration and degradation of the battery, a technology for managing the operation of battery cells and modules is required.

Conventional commercial battery packs for electric vehicles have the problem in that they cannot supply power to loads having various rated voltages because they do not include a conversion unit inside the battery pack. In addition, when modifying a battery pack to supply power to loads with various rated voltages, there is a problem that the life of the battery pack is shortened and the risk of fire increases due to overdischarging of a specific battery unit among the battery units included in the battery pack.

### DISCLOSURE OF THE INVENTION

### TECHNICAL PROBLEM

An objective of the embodiments disclosed in this document is to provide a battery pack including a conversion unit inside the battery pack so as to supply power to loads having various rated voltages, and an operating method thereof.

An objective of the embodiments disclosed in this document is to provide a battery pack capable of managing charging and discharging of a plurality of battery units included in the battery pack and an operating method thereof.

The technical problems of the embodiments disclosed in this document are not limited to the technical problems mentioned above, and other technical problems not mentioned will be clearly understood by those skilled in the art from the descriptions below.

### TECHNICAL SOLUTION

A battery pack according to an embodiment of this document may include a conversion unit that converts a total voltage output from a first battery unit and a second battery unit into an intermediate voltage, a switch circuit unit that switches an electrical connection between the conversion unit and the first battery unit and a load, and a controller that controls an operation of the switch circuit unit to charge the first battery unit and supply power to the load using the intermediate voltage.

According to an embodiment, the switch circuit unit may include a first switch that switches an electrical connection between the conversion unit and the first battery unit and a second switch that switches an electrical connection between the conversion unit and the load.

According to an embodiment, the controller may short-circuit the second switch when power is required to be supplied for the load.

According to an embodiment, the battery pack may further include an acquisition unit that acquires voltages of the first battery unit and the second battery unit, and the controller may compare the voltage of the first battery unit with the voltage of the second battery unit, and may short-circuit the first switch when a difference between the voltage of the second battery unit and the voltage of the first battery unit is greater than or equal to a threshold value.

According to an embodiment, the controller may short-circuit the first switch until the difference value becomes a value smaller than the threshold value.

According to an embodiment, the controller may receive a state signal from each of the first battery unit, the second battery unit, and the conversion unit, and may determine the first battery unit, the second battery unit, or the conversion unit is in a failure state when the state signal is not received for a predetermined time.

According to an embodiment, the controller may open the first switch when determining that the first battery unit is in the failure state, and may open the first switch and the second switch when determining that the conversion unit or the second battery unit is in the failure state.

According to an embodiment, the conversion unit, the switch circuit unit, and the controller may be configured as a single integrated circuit.

An operating method of a battery pack according to an embodiment of this document may include the steps of converting a total voltage output from a first battery unit and a second battery unit into an intermediate voltage through a conversion unit, switching an electrical connection between the conversion unit and the first battery unit and a load through a switch circuit unit, and controlling an operation of the switch circuit unit to charge the first battery unit and supply power to the load using the intermediate voltage.

According to an embodiment, the switch circuit unit may include a first switch that switches an electrical connection between the conversion unit and the first battery unit and a second switch that switches an electrical connection between the conversion unit and the load.

According to an embodiment, the step of switching may include a step of short-circuiting the second switch when power is required to be supplied for the load.

According to an embodiment, the operating method may further include a step of acquiring voltages of the first battery unit and the second battery unit, and the step of switching may include the steps of comparing the voltage of the first battery unit with the voltage of the second battery unit and short-circuiting the first switch when a difference between the voltage of the second battery unit and the voltage of the first battery unit is greater than or equal to a threshold value.

According to an embodiment, the first switch may be short-circuited until the difference value becomes a value smaller than the threshold value.

According to an embodiment, the operating method may further include the steps of receiving a state signal from each of the first battery unit, the second battery unit, and the conversion unit, and determining the first battery unit, the second battery unit, or the conversion unit is in a failure state when the state signal is not received for a predetermined time.

According to an embodiment, the operating method may further include the steps of opening the first switch when determining that the first battery unit is in the failure state, and opening the first switch and the second switch when determining that the conversion unit or the second battery unit is in the failure state.

According to an embodiment, the steps of the operating method of the battery pack may be performed in a single integrated circuit.

### ADVANTAGEOUS EFFECTS

The battery pack and operating method thereof disclosed in this document can supply power to loads having various rated voltages by using a conversion unit included inside the battery pack.

The battery pack and the operating method thereof disclosed in this document can manage charging and discharging of a plurality of battery units included in the battery pack.

In addition, various effects that are directly or indirectly identified through this document may be provided.

### BRIEF DESCRIPTION OF THE DRAWINGS

FIG. 1 is a block diagram illustrating a battery pack according to an embodiment disclosed in this document.
FIG. 2a is a graph illustrating voltages of a first battery unit and a second battery unit according to an embodiment disclosed in this document.
FIG. 2b is a graph illustrating voltages of a first battery unit and a second battery unit according to an embodiment disclosed in this document.
FIG. 3 is a circuit diagram illustrating a battery pack according to an embodiment disclosed in this document.
FIG. 4 is a flowchart illustrating an operation of a battery pack according to an embodiment disclosed in this document.
FIG. 5 is a block diagram illustrating a hardware configuration of a computing system for performing an operating method of a battery pack according to an embodiment disclosed in this document.

### MODE FOR CARRYING OUT THE INVENTION

Hereinafter, embodiments described in this document are described with reference to the accompanying drawings. However, this is not intended to limit the disclosure of this document to a specific embodiment, but should be understood to include various modifications, equivalents, and/or alternatives of the embodiments described in this document.

Various embodiments of this document and the terms used therein are not intended to limit the technical features described in this document to a specific embodiment, but should be understood to include various modifications, equivalents, or alternatives of the embodiment. In connection with the description of the drawings, similar reference numerals may be used for similar or related components. The singular form of a noun corresponding to an item may include one or more of said items, unless the context clearly indicates otherwise.

In this document, each of phrases "A or B", "at least one of A and B", "at least one of A or B", "A, B, or C", "at least one of A, B, and C", and "at least one of A, B, or C" may include any one of the items listed together in that phrase, or all possible combinations thereof. Terms such as "first", "second", "firstly", "secondly", "A", "B", "(a)", or "(b)" may be used merely to distinguish one component from another, and do not limit the components in any other respect (e.g., importance or order) unless specifically stated otherwise.

In this document, when a component (e.g., a first component) is referred to as being "connected", "coupled" or "joined" to another component (e.g., a second component), with or without the terms "functionally" or "communicatively", it means that the component can be connected to the other component directly (e.g., in a wired manner), wirelessly, or through a third component.

According to an embodiment, a method according to various embodiments disclosed in this document may be provided by being included in a computer program product. The computer program product may be traded between a seller and a buyer as a product. The computer program product may be distributed in the form of a machine-readable storage medium (e.g., compact disc read only memory (CD-ROM)), or may be distributed online (e.g., downloaded or uploaded) through an application store or directly between two user devices. In the case of online distribution, at least a part of the computer program product may be temporarily stored or temporarily generated in a machine-readable storage medium such as a memory of a manufacturer's server, an application store's server, a relay server.

According to various embodiments, each of the components (e.g., modules or programs) described above may include a single or plurality of entities, and some of the plurality of entities may be separated and placed in other components. According to various embodiments, one or more of the components or operations described above may be omitted, or one or more other components or operations may be added. Alternatively or additionally, a plurality of components (e.g., modules or programs) may be integrated into a single component. In such a case, the integrated component may perform one or more functions of each of the plurality of components identically or similarly to those performed by the corresponding component among the plurality of components prior to the integration. According to various embodiments, the operations performed by a module, program, or other component may be performed sequentially, in parallel, repeatedly, or heuristically, or one or more of the operations may be performed in a different order, omitted, or performed by being added with one or more other operations.

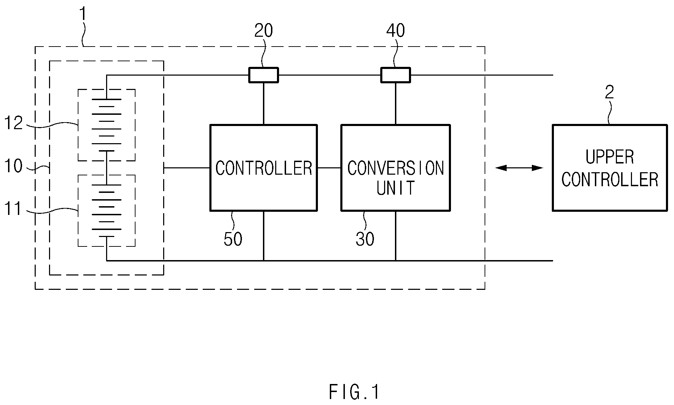

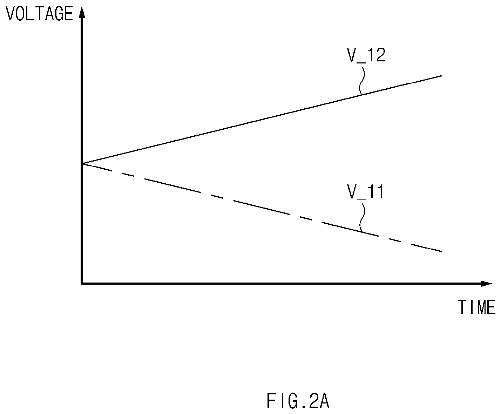

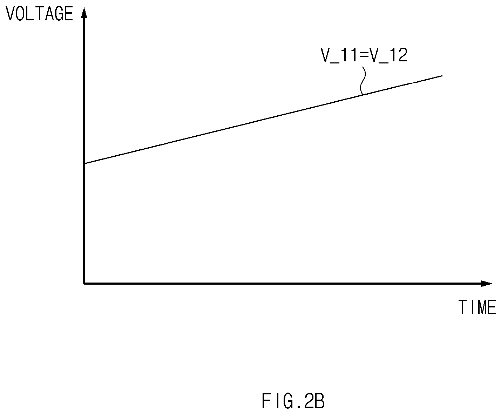

FIG. 1 is a block diagram illustrating a battery pack according to an embodiment disclosed in this document. FIG. 1 schematically illustrates a battery control system including a battery pack 1 and an upper controller 2 included in an upper system. FIGS. 2a and 2b are graphs illustrating voltages of a first battery unit and a second battery unit according to an embodiment disclosed in this document.

First, referring to FIG. 1, the battery pack 1 may include a plurality of battery units 10, an acquisition unit 20, a conversion unit 30, a switch circuit unit 40, and a controller 50. In this case, the battery pack 1 may be equipped with a plurality of the plurality of battery units 10, the acquisition units 20, the conversion units 30, and the switch circuit units 40.

According to the embodiment, the plurality of battery units 10 may supply power to a target device (not illustrated). To this end, the plurality of battery units 10 may be electrically connected to the target device. Here, the target device may include an electrical, electronic, or mechanical device that operates by receiving power from the battery pack 1. For example, the target device may be an electric vehicle (EV) or an energy storage system (ESS), but is not limited thereto.

According to the embodiment, the plurality of battery units 10 may include a first battery unit 11 and a second battery unit 12. According to the embodiment, the first battery unit 11 and the second battery unit 12 may be connected in series. In this case, the first battery unit 11 may refer to a battery unit connected to a ground terminal or a battery unit located at the bottom.

According to the embodiment, the first battery unit 11 and the second battery unit 12 may include at least one battery cell capable of being charged and discharged, and the battery cell may be a basic unit of the battery cell capable of being used by charging and discharging electric energy. For example, the battery cell may be a lithium-ion (Li-ion) battery, a lithium-ion polymer (Li-ion polymer) battery, a nickel-cadmium (Ni-Cd) battery, a nickel-metal hydride (Ni-MH) battery, etc., but is not limited thereto. For example, each of the first battery unit 11 and the second battery unit 12 may be a battery module, a battery bank, or a set of battery cells. According to the embodiment, each of the first battery unit 11 and the second battery unit 12 may include four battery cells.

According to the embodiment, a plurality of battery units 10 may supply power to one or more loads. Here, when the target device is an electric vehicle, the load may refer to electric equipment inside the vehicle. According to the embodiment, a rated voltage of each of the plurality of loads included inside the vehicle may be different depending on the load. For example, the rated voltage of a first load may be 12 V, and the rated voltage of a second load may be 24 V.

According to various embodiments, the conventional commercial battery pack for an electric vehicle may not include the conversion unit 30 inside the battery pack. Therefore, when there are a plurality of loads, the conventional battery pack can only supply power to loads having the same rated voltage. Therefore, users installed separate power conversion devices to use electric equipment having different rated voltages. Due to this, there has been a problem in that the installation cost of the power conversion device increases and the safety of the battery pack decrease.

However, the battery pack 1 according to the embodiment includes the conversion unit 30 inside the battery pack 1, so that the battery pack 1 can supply voltage corresponding to the rated voltage of each of the plurality of loads having different rated voltages by using the voltage converted by the conversion unit 30 without a separate power conversion device. For example, the battery pack 1 may include the switch circuit unit 40 that switches the electrical connection between the conversion unit 30 and each of the plurality of loads. Through this, the battery pack 1 may maintain the safety of the battery pack 1 by cutting off supply of power to the load when the conversion unit 30 is in a failure state.

In addition, the battery pack 1 according to the embodiment includes the conversion unit 30 inside the battery pack 1, and thus the first battery unit 11 may be charged using the voltage converted by the conversion unit 30. Regarding this, referring to FIG. 2(a) and FIG. 2b, FIG. 2a illustrates the voltage behavior of the first battery unit 11 and the second battery unit 12 in a typical battery pack, and FIG. 2b illustrates the voltage behavior of the first battery unit 11 and the second battery unit 12 in the battery pack 1 including the conversion unit 30.

Referring to FIG. 2a, in the case of a typical commercial battery pack for an electric vehicle, power may be supplied to a load having a rated voltage of 12 V using a voltage output from the first battery unit 11. Therefore, as illustrated in FIG. 2a, in a discharge state of the battery pack, a voltage V_11 of the first battery unit 11 may be lower than a voltage V_12 of the second battery unit 12, and as a discharge time of the battery pack 1 increases, a difference between the voltage V_11 of the first battery unit 11 and the voltage V_12 of the second battery unit 12 may become larger. Due to this, there was a problem in that the voltage of the first battery unit 11 located at the bottom decreased compared to the voltage of the second battery unit 12 located at the top.

In contrast, referring to FIG. 2b, in a discharge state of the battery pack 1 including the conversion unit 30 according to the embodiment, the battery pack 1 may charge the first battery unit 11 using the voltage converted by the conversion unit 30. Accordingly, the voltage V_11 of the first battery unit 11 may be managed to have a value corresponding to the voltage V_12 of the second battery unit 12.

In addition, according to the embodiment, the battery pack 1 may include the switch circuit unit 40 that switches the electrical connection between the conversion unit 30 and each of the first battery unit 11 and the second battery unit 12. Through this, the battery pack 1 may charge the first battery unit 11 by connecting the conversion unit 30 and the first battery unit 11 when charging of the first battery unit 11 is required, and may disconnect the connection when charging is not required. In addition, the battery pack 1 may control the switch circuit unit 40 to maintain the safety of the battery pack 1 even when the conversion unit 30 or the first battery unit 11 and the second battery unit 12 are in a failure state.

According to the embodiment, the acquisition unit 20 may acquire information related to the plurality of battery units 10. According to the embodiment, the acquisition unit 20 may acquire values (or information) related to a state of each of the plurality of battery units 10. In an embodiment, the values related to the state may include one or more values for voltage, current, resistance, state of charge (SOC), state of health (SOH), or temperature, a combination thereof of the battery cells included in the plurality of battery units 10. For example, the acquisition unit 20 may acquire the voltages of the first battery unit 11 and the second battery unit 12.

According to the embodiment, the acquisition unit 20 may acquire the voltage of each of the first battery unit 11 and the second battery unit 12 in each unit time. According to an embodiment, the acquisition unit 20 may continuously acquire voltage data in a charging section, a resting section after charging, a discharging section, and/or a resting section after discharging of a plurality of battery cells over time. According to the embodiment, the acquisition unit 20 may include a voltage monitoring circuit or sensor.

According to the embodiment, the conversion unit 30 may convert the voltage output from the plurality of battery units 10. For example, the conversion unit 30 may include a DC-DC converter. According to the embodiment, the conversion unit 30 may convert a total voltage output from the first battery unit 11 and the second battery unit 12 into an intermediate voltage. Here, when the conversion unit 30 operates as a step-up converter, the intermediate voltage may be greater than the total voltage. In addition, when the conversion unit 30 operates as a step-down converter, the intermediate voltage may be less than the overall voltage.

According to the embodiment, the conversion unit 30 may convert the voltage output from a generator (not illustrated) included in the electric vehicle into an intermediate voltage. For example, when the plurality of battery units 10 are discharged, the conversion unit 30 may convert the power of the generator. Through this, the conversion unit 30 may charge the first battery unit 11 or supply power to the load even when the battery units are discharged.

According to the embodiment, the switch circuit unit 40 may switch a connection between the battery pack 1 and one or more loads. In addition, the switch circuit unit 40 may switch the electrical connection between other components (e.g., the plurality of battery units 10, the first battery unit 11 and the second battery unit 12, the acquisition unit 20, the conversion unit 30, and the controller 50) included in the battery pack 1.

According to an embodiment, the switch circuit unit 40 may include a device for controlling the current flow for charging or discharging of the plurality of battery units 10. For example, the switch circuit unit 40 may include at least one relay and/or magnetic contactor, etc., depending on the specifications of the battery pack 1. According to the embodiment, the switch circuit unit 40 may include an electronic switch, such as a field effect transistor (FET).

According to the embodiment, the controller 50 may control or manage the battery pack 1 to prevent overcharging and overdischarging by monitoring the voltage, current, temperature, etc. of the battery pack 1. Here, the controller 50 may perform the function of a battery management system (BMS).

According to the embodiment, the controller 50 may include a plurality of terminals that receive various types of information described above from the acquisition unit 20, and a circuit that is connected to these terminals and processes the received values. In addition, the controller 50 may control the acquisition unit 20, the conversion unit 30, and/or the switch circuit unit 40. For example, the controller 50 may be connected to the plurality of battery units 10 to monitor the state of each of the first battery unit 11 and the second battery unit 12, and control the operation of a switch such as a relay or FET.

According to the embodiment, the controller 50 may perform ON/OFF control of the electrical connection between the conversion unit 30 and at least one battery unit or the electrical connection between the conversion unit 30 and at least one load through the switch circuit unit 40. For example, the controller 50 may control the operation of the switch circuit unit 40 to charge the first battery unit 11 and supply power to the load using the intermediate voltage. Through this, the controller 50 may operate the load and simultaneously charge the first battery unit 11 based on the converted intermediate voltage.

According to the embodiment, the operation of the controller 50 may be performed by the battery management system (BMS) within the vehicle, and may be performed in various devices such as a server, a cloud, a charger, or a charger/discharger.

According to the embodiment, the upper controller 2 may transmit a control signal for the plurality of battery units 10 to the controller 50. Accordingly, the operation of the controller 50 may be controlled based on the signal applied from the upper controller 2.

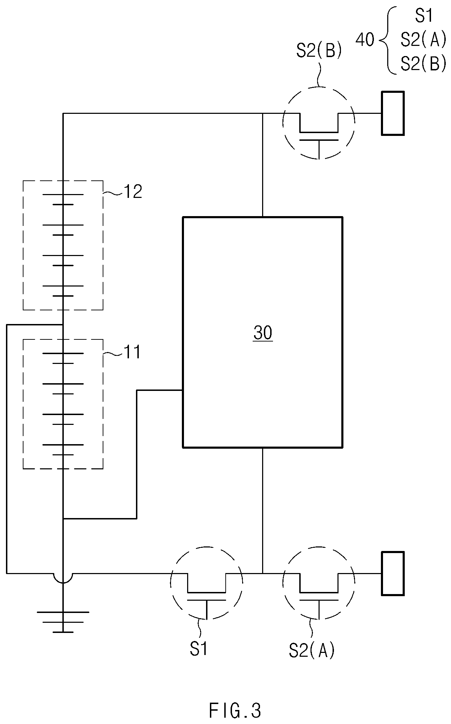

FIG. 3 is a circuit diagram illustrating a battery pack according to an embodiment disclosed in this document.

Referring to FIG. 3, the conversion unit 30 may convert a voltage, which is input to the conversion unit 30, into a voltage having a value corresponding to half the magnitude of the input voltage. In another aspect, the intermediate voltage may have a value corresponding to half the voltage input to the conversion unit 30. For example, when the voltage of the first battery unit 11 is 12 V and the voltage of the second battery unit 12 is 12 V, the conversion unit 30 may convert a voltage of 24 V output from the first battery unit 11 and the second battery unit 12 into an intermediate voltage of 12 V. In addition, when an output voltage of the generator is 28 V, the conversion unit 30 may convert the voltage of 28 V into an intermediate voltage of 14 V.

According to the embodiment, the controller 50 may apply the intermediate voltage of 12 V or 14 V to a load having the rated voltage 12 V and the first battery unit 11 of 12 V. In addition, the controller 50 may apply the voltage of 24 V output from the first battery unit 11 and the second battery unit 12 to a load having rated voltage of 24 V without conversion. In addition, by converting the voltage of 28 V into the intermediate voltage of 24 V in the conversion unit 30, the controller 50 may apply the voltage of 24 V to the load having the rated voltage of 24 V. Through this, the battery pack 1 may supply power to various loads or charge the first battery unit 11 based on the voltage output from the first battery unit 11 and the second battery unit 12 or the voltage output from the generator.

According to the embodiment, the switch circuit unit 40 may include at least one switch that turns ON/OFF the connection between the conversion unit 30 and each of the plurality of battery units 10, or turns ON/OFF the connection between the conversion unit 30 and each of a plurality of loads. According to the embodiment, the controller 50 may control the ON/OFF operation of the switch included in the switch circuit unit 40.

According to the embodiment, the switch circuit unit 40 may include a first switch S1 that switches the electrical connection between the conversion unit 30 and the first battery unit 11. In addition, the switch circuit unit 40 may include a second switch S2 that switches the electrical connection between the conversion unit 30 and the load. Here, when there are a plurality of loads, the second switch S2 may include a plurality of second switches S2 that connect the conversion unit 30 and each of the loads. For example, a second switch S2(A) may switch a connection between the conversion unit 30 and a load A, and a second switch S2(B) may switch a connection between the conversion unit 30 and a load B. Here, the rated voltages of the load A and the load B may be different.

According to the embodiment, the controller 50 may control the second switch S2 based on whether power is required to be supplied for the load. For example, the controller 50 may short-circuit the second switch S2 when power is required to be supplied for the load. In addition, the controller 50 may open the second switch when power is not required to be supplied to the load.

According to the embodiment, the controller 50 may control the first switch S1 based on whether charging of the first battery unit 11 is required. For example, the controller 50 may short-circuit the first switch S1 when charging of the first battery unit 11 is required. In addition, the controller 50 may open the first switch S1 when charging of the first battery unit 11 is not required.

According to the embodiment, the controller 50 may determine whether charging of the first battery unit 11 is required based on a voltage difference between the first battery unit 11 and the second battery unit 12. For example, when the voltage of the first battery unit 11 is lower than the voltage of the second battery unit 12, the controller 50 may determine that charging of the first battery unit 11 is required. Also, the controller 50 may charge the first battery unit 11 using the intermediate voltage so that the voltage of the first battery unit 11 has a value corresponding to the voltage of the second battery unit 12. Through this, the controller 50 may maintain voltage levels of the first battery unit 11 and the second battery unit 12 to be the same.

In contrast, according to the embodiment, when the voltage of the first battery unit 11 is the same as the voltage of the second battery unit 12, the controller 50 may determine that charging of the first battery unit 11 is not required.

According to the embodiment, the controller 50 may compare the voltage of the first battery unit 11 and the voltage of the second battery unit 12. Also, when the difference between the voltage of the second battery unit 12 and the voltage of the first battery unit 11 is greater than or equal to a threshold value, the controller 50 may short-circuit the first switch S1. Here, the threshold value may refer to an error range within which the voltage of the first battery unit 11 may be considered to be the same as the voltage of the second battery unit 12. For example, the threshold value may be 0.1 V, but is not limited thereto, and may vary depending on the voltages of the first battery unit 11 and the second battery unit 12.

According to the embodiment, the controller 50 may short-circuit the first switch S1 until a difference value between the voltage of the second battery unit 12 and the voltage of the first battery unit 11 becomes a value smaller than the threshold value. Through this, the controller 50 may charge the first battery unit 11 using the intermediate voltage until the voltage of the first battery unit 11 becomes a value corresponding to the voltage of the second battery unit 12.

According to the embodiment, the controller 50 may receive a state signal from each of the first battery unit 11, the second battery unit 12, and the conversion unit 30. Here, the state signal may be a signal indicating that each component included in the battery pack 1 is operating normally. For example, the state signal may mean a health signal. According to an embodiment, when the controller 50 receives the state signal from a specific component (e.g., a conversion unit 30) at regular time intervals, the controller 50 may determine that the specific component is in a normal state.

According to the embodiment, when a state signal is not received from that component for a predetermined period of time, the controller 50 may determine that the specific component is in a failure state. Here, the component may refer to the first battery unit 11, the second battery unit 12, or the conversion unit 30. Through this, the controller 50 may check whether the first battery unit 11, the second battery unit 12, or the conversion unit 30 included in the battery pack 1 is operating normally.

According to the embodiment, when the controller 50 determines that a specific component is in a failure state, the controller 50 may control the switch circuit unit 40 to cut off the electrical connection between the specific component and other components. For example, when the controller 50 determines that the first battery unit 11 is in a failure state, the controller 50 may open the first switch S1. Through this, the controller 50 may protect the conversion unit 30 and the first battery unit 11 by cutting off the power supplied from the conversion unit 30 to the first battery unit 11.

In addition, for example, when the controller 50 determines that the conversion unit 30 or the second battery unit 12 is in a failure state, the controller 50 may open the first switch S1 and the second switch S2. Through this, the controller 50 may protect the conversion unit 30 and the first battery unit 11 by cutting off the power supplied from the conversion unit 30 to the first battery unit 11. In addition, the controller 50 may protect the load by cutting off the power supplied from the conversion unit 30 to the load.

According to the embodiment, when it is checked that there is failure in the first battery unit 11, the second battery unit 12, or the conversion unit 30, the controller 50 may provide information about a failure part to the user. For example, the controller 50 may provide information about an abnormal component to the user terminal through a communication circuit (not illustrated), and may also provide information about the abnormal component through a display equipped in a vehicle or a charger, etc.

According to the embodiment, the controller 50 may provide information about the voltage of each of the first battery unit 11 and the second battery unit 12 to the user. In addition, the controller 50 may provide information about an intermediate voltage converted by the conversion unit 30 and a ratio at which the intermediate voltage is supplied to the load and the first battery unit 11 to the user. For example, the controller 50 may provide information about the voltage to the user terminal through the communication circuit (not illustrated), and may also provide information about the voltage through the display equipped in the vehicle or a charger.

According to the embodiment, the conversion unit 30, the switch circuit unit 40, and the controller 50 may be configured as an integrated circuit. Here, one integrated circuit may mean a micro control unit (MCU) having a multicore. Therefore, the single integrated circuit may perform functions of the controller 50, the conversion unit 30, and the switch circuit unit 40. This integrated circuit design may reduce the complexity of system by reducing wiring between the components (e.g., the BMS, the conversion unit 30, and the switch circuit unit 40). In addition, the integrated circuit design may reduce the size of the battery pack 1 and suppress a temperature rise of the battery pack 1 by reducing heat emitted from each component.

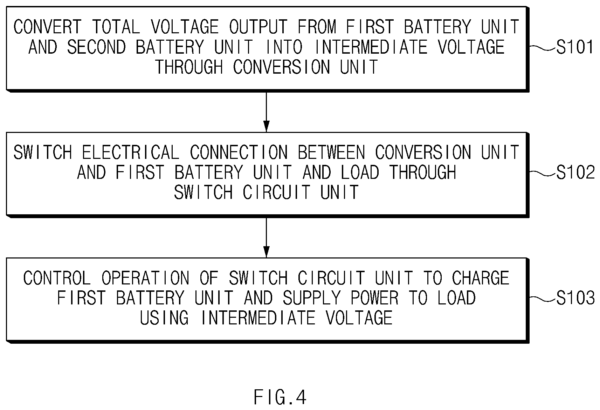

FIG. 4 is a flowchart illustrating the operation of a battery pack according to an embodiment disclosed in this document. The operation steps of FIG. 4 may be understood with reference to FIGS. 1 to 3.

Referring to FIG. 4, a battery pack may convert a total voltage output from a first battery unit and a second battery unit into an intermediate voltage through a conversion unit (S101), switch an electrical connection between the conversion unit and the first battery unit and the load through a switch circuit unit (S102), and control the operation of the switch circuit unit so as to charge the first battery unit and supply power to the load using the intermediate voltage (S103).

In step S101, the battery pack 1 may convert the total voltage output from the first battery unit 11 and the second battery unit 12 into an intermediate voltage through the conversion unit 30 (S101).

In step S102, the battery pack 1 may switch the electrical connection between the conversion unit and the first battery unit 11 and the load through the switch circuit unit 40 (S102). According to the embodiment, the switch circuit unit 40 may include the first switch S1 that switches the electrical connection between the conversion unit 30 and the first battery unit 11 and the second switch S2 that switches the electrical connection between the conversion unit 30 and the load.

In step S103, the battery pack 1 may control the operation of the switch circuit unit 40 so as to charge the first battery unit 11 and supply power to the load using the intermediate voltage (S103).

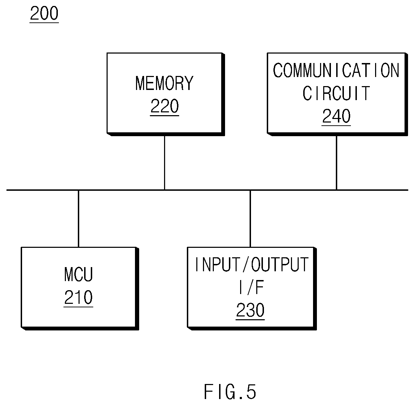

FIG. 5 is a block diagram illustrating a hardware configuration of a computing system for performing an operating method of a battery pack according to an embodiment disclosed in this document.

Referring to FIG. 5, a computing system 200 according to an embodiment disclosed in this document may include an MCU 210, a memory 220, an input/output I/F 230, and a communication I/F 240.

The MCU 210 may be a processor that executes various programs (e.g., battery cell data collection programs, graph generation programs, data analysis programs, data decomposition algorithms, normalization programs, and battery cell diagnosis programs, etc.) stored in the memory 220, processes various information including battery cell characteristic data, latent variables, etc. through these programs, and performs the functions of the battery pack 1 described with reference to FIGS. 1 to 4.

The memory 220 may store various programs such as battery cell data collection programs, graph generation programs, data analysis programs, data decomposition algorithms, normalization programs, and battery cell diagnosis programs, etc.

A plurality of such memories 220 may be provided as needed. The memory 220 may be a volatile memory or a nonvolatile memory. As the memory 220 as the volatile memory, RAM, DRAM, SRAM, etc. may be used. As the memory 220 as the non-volatile memory, ROM, PROM, EAROM, EPROM, EEPROM, flash memory, etc. may be used. The examples of the memories 220 listed above are only examples and the memories 1020 are not limited to these examples.

The input/output I/F 230 may provide an interface that connects an input device (not illustrated) such as a keyboard, mouse, or touch panel and an output device such as a display (not illustrated) with the MCU 210 to transmit and receive data therebetween.

The communication I/F 240 may be a configuration that can transmit and receive various data to and from a server, and may be various devices that can support wired or wireless communication. For example, the battery management device 100 may transmit and receive various types of information, including a shape model of the battery cell, from a separately provided external server through the communication I/F (240).

In this way, a computer program according to an embodiment disclosed in this document may be implemented as a module that performs each function illustrated in FIG. 4, for example, by being recorded in the memory 220 and processed by the MCU 210.

In the above, even though all the components constituting the embodiment disclosed in this document have been described as being combined as one or operating in combination, the embodiments disclosed in this document are not necessarily limited to the embodiment. That is, within the scope of the objective of the embodiments disclosed in this document, all of the components may be operated by selectively combining one or more of them.

The terms "include," "configure," or "have" described above, unless specifically stated to the contrary, mean that the corresponding component may be included, and therefore should be interpreted as further including other components rather than excluding other components. All terms including technical or scientific terms have the same meaning as commonly understood by a person skilled in the art to which the embodiments disclosed in this document belong, unless otherwise defined. Terms commonly used, such as terms defined in the dictionary, should be interpreted as being consistent with the contextual meaning of the relevant technology, and should not be interpreted in an idealized or overly formal sense unless clearly defined in this document.

The above-mentioned disclosure outlines the features of some embodiments so that those skilled in the art may better understand the aspects of the present disclosure. Those skilled in the art will understand that the present disclosure may be easily used as a basis for designing or modifying other structures to perform the same purposes or achieve the same advantages of the embodiments introduced herein. Furthermore, those skilled in the art will recognize that such equivalent configuration do not depart from the scope of the present disclosure, and that various changes, substitutions, and modifications may be made herein without departing from the scope of the present disclosure.

### [Description of reference numerals]

1: battery pack
2: upper controller
10: plurality of battery cells
11: first battery unit
12: second battery unit
20: acquisition unit
30: conversion unit
40: switch circuit unit
50: controller
200: computing system
210: MCU
220: memory
230: input/output I/F
240: communication I/F

## Claims

1. A battery pack comprising:
a conversion unit that converts a total voltage output from a first battery unit and a second battery unit into an intermediate voltage;
a switch circuit unit that switches an electrical connection between the conversion unit and the first battery unit and a load; and
a controller that controls an operation of the switch circuit unit to charge the first battery unit and supply power to the load using the intermediate voltage.

2. The battery pack of claim 1, wherein the switch circuit unit includes:
a first switch that switches an electrical connection between the conversion unit and the first battery unit; and
a second switch that switches an electrical connection between the conversion unit and the load.

3. The battery pack of claim 2, wherein the controller short-circuits the second switch when power is required to be supplied for the load.

4. The battery pack of claim 2, further comprising:
an acquisition unit that acquires voltages of the first battery unit and the second battery unit,
wherein the controller compares the voltage of the first battery unit with the voltage of the second battery unit, and short-circuits the first switch when a difference between the voltage of the second battery unit and the voltage of the first battery unit is greater than or equal to a threshold value.

5. The battery pack of claim 4, wherein the controller short-circuits the first switch until the difference value becomes a value smaller than the threshold value.

6. The battery pack of claim 2, wherein the controller receives a state signal from each of the first battery unit, the second battery unit, and the conversion unit, and
determines the first battery unit, the second battery unit, or the conversion unit is in a failure state when the state signal is not received for a predetermined time.

7. The battery pack of claim 6, wherein the controller opens the first switch when determining that the first battery unit is in the failure state, and
opens the first switch and the second switch when determining that the conversion unit or the second battery unit is in the failure state.

8. The battery pack of claim 1, wherein the conversion unit, the switch circuit unit, and the controller are configured as a single integrated circuit.

9. An operating method of a battery pack, the method comprising the steps of:
converting a total voltage output from a first battery unit and a second battery unit into an intermediate voltage through a conversion unit;
switching an electrical connection between the conversion unit and the first battery unit and a load through a switch circuit unit; and
controlling an operation of the switch circuit unit to charge the first battery unit and supply power to the load using the intermediate voltage.

10. The operating method of claim 9, wherein the switch circuit unit includes:
a first switch that switches an electrical connection between the conversion unit and the first battery unit; and
a second switch that switches an electrical connection between the conversion unit and the load.

11. The operating method of claim 10, wherein the step of switching includes a step of short-circuiting the second switch when power is required to be supplied for the load.

12. The operating method of claim 10, further comprising:
a step of acquiring voltages of the first battery unit and the second battery unit,
wherein the step of switching includes the steps of:
comparing the voltage of the first battery unit with the voltage of the second battery unit; and
short-circuiting the first switch when a difference between the voltage of the second battery unit and the voltage of the first battery unit is greater than or equal to a threshold value.

13. The operating method of claim 12, wherein the first switch is short-circuited until the difference value becomes a value smaller than the threshold value.

14. The operating method of claim 10, further comprising the steps of:
receiving a state signal from each of the first battery unit, the second battery unit, and the conversion unit; and
determining the first battery unit, the second battery unit, or the conversion unit is in a failure state when the state signal is not received for a predetermined time.

15. The operating method of claim 14, further comprising the steps of:
opening the first switch when determining that the first battery unit is in the failure state; and
opening the first switch and the second switch when determining that the conversion unit or the second battery unit is in the failure state.

16. The operating method of claim 9, wherein the steps of the operating method of the battery pack is performed in a single integrated circuit.
